# EUROPEAN PATENT SPECIFICATION

(11) **EP 0 865 084 B1**
(45) Date of publication and mention of the grant of the patent: **25.09.2002**
(21) Application number: 97400530.8
(22) Date of filing: 10.03.1997
(51) Int. Cl.: H01L 27/02, G01N 27/12

(54) **Sensor device having ESD protection and method of fabricating such a sensor device**
Sensorbauelement mit ESD-Schutz und Herstellungsverfahren eines solchen Sensorbauelements
Dispositif de détection ayant une protection ESD et procédé de fabrication d'un tel dispositif de détection

(43) Date of publication of application: 16.09.1998
(73) Proprietor: MOTOROLA SEMICONDUCTEURS S.A., 31023 Toulouse Cédex (FR)
(72) Inventor: Lescouzères, Lionel, 31100 Toulouse (FR); Combes, Myriam, 31830 Toulouse (FR); Gimbre, Martine, 31880 Toulouse (FR)
(74) Representative: Gibson, Sarah Jane

(56) References cited:
- EP-A- 0 066 851
- US-A- 4 414 839

## Description

### Field of the Invention

This invention relates to a sensor device having ESD protection and a method of fabricating a sensor device having ESD protection.

### Background of the Invention

Some sensor devices, such as semiconductor chemical sensor devices, have a sensitive layer and a heater for heating the sensitive layer, formed on a semiconductor substrate. The heater and sensitive layer are separated by an isolation layer and both have contacts extending thereto.

During fabrication of such sensor devices and until the devices are assembled on a board, such sensors are susceptible to damage induced by Electro-Static Discharge (ESD). For example, ESD pulses of up to 2000 volts may be applied across the contacts of the sensor device whilst an operator handles the device during test and assembly. When 2000 volt pulses are applied across the isolation layer, significant damage is induced in the isolation layer due to breakdown, which makes the device unusable. The problems due to ESD sensitivity of such sensor devices produces a reduction in fabrication yield.

There is therefore a need to provide ESD protection for sensor devices.

Further sensors are disclosed in EP 66851 and US 4414839.

### Summary of the Invention

In accordance with a first aspect of the present invention there is provided a sensor device as claimed in claim 1.

In accordance with a second aspect of the present invention there is provided a method of fabricating a sensor device as claimed in claim 3.

### Brief Description of the Drawings

Exemplary embodiments of the present invention will now be described with reference to the accompanying drawings in which:
FIG. 1 is an electrical schematic diagram of a sensor device in accordance with the present invention;
FIG. 2 is a schematic plan view of a first sensor device in accordance with a first embodiment of the present invention;
FIGs. 3-9 are schematic cross-section views of the first sensor device of FIG. 2 during various stages of fabrication; and
FIGs. 10-15 are schematic cross-section views of a second sensor device in accordance with a second embodiment of the present invention during various stages of fabrication.

### Detailed Description of the Drawings

In the following description, the invention will be described in relation to a semiconductor chemical sensor device. It will however be appreciated that the invention may apply to any other sensor devices comprising a sensitive layer, which layer is sensitive to a parameter to be sensed by the sensor device, and a heater for heating the sensitive layer, such as biosensors.

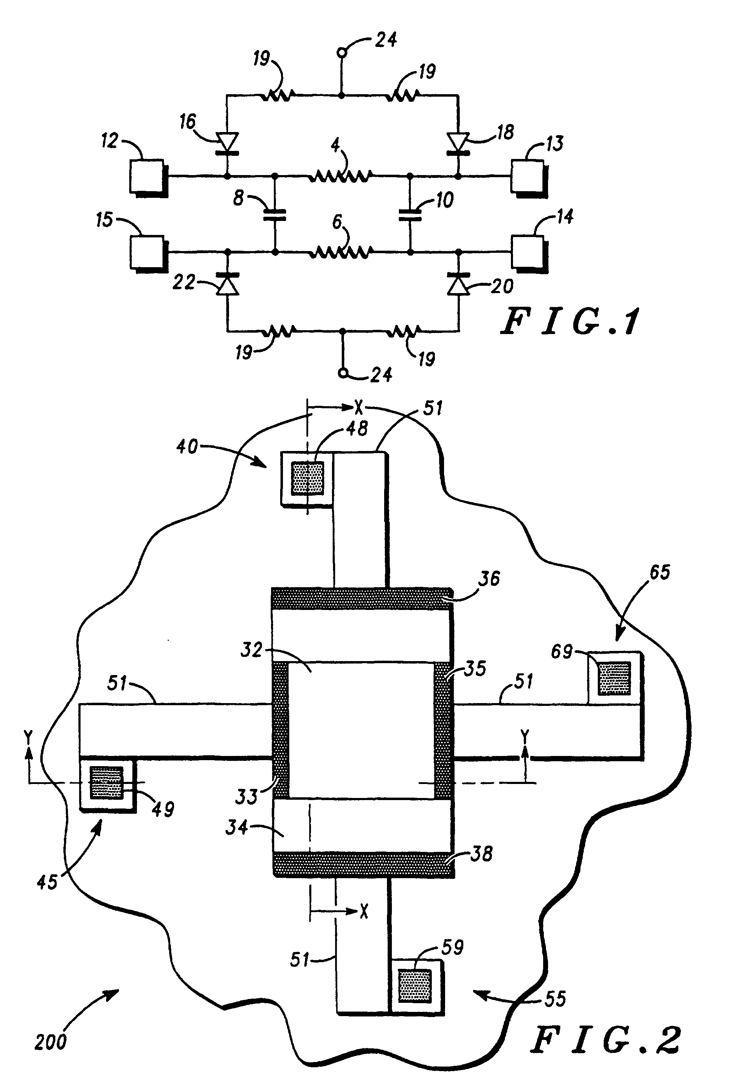

FIG. 1 shows an electrical schematic diagram of a semiconductor chemical sensor device in accordance with the present invention. The semiconductor chemical sensor device is integrated on a semiconductor substrate (not shown in FIG. 1) and comprises a sensitive layer which in FIG. 1 is represented by a resistor 4, a heater which is represented by a resistor 6, and an isolation layer, between the heater and sensitive layer which is represented by capacitors 8 and 10. The sensitive layer has contacts 12, 13 coupled thereto and the heater has contacts 14, 15 coupled thereto.

The semiconductor chemical sensor device in accordance with the present invention further comprises protection diodes 16, 18, 20, 22 coupled to the contacts 12, 13 of the sensitive layer and to the contacts 14, 15 of the heater so as to provide ESD protection. Each one of the protection diodes 16, 18, 20, 22 is coupled between a respective one of the contacts 12, 13, 14, 15 and, at node 24, the semiconductor substrate (which is floating). In other words, each of the contacts 12, 13, 14 and 15 are coupled to the semiconductor substrate via a protection diode. The resistance of the semiconductor substrate is represented by resistors 19.

In view of the resistance of the sensitive layer resistor 4 and the heater resistor 6, ESD pulses applied across the contacts 12 and 13 and across the contacts 14 and 15 do not cause any device damage. Since the isolation layer can typically only support ESD pulses of up to 250V before breakdown, it is the ESD pulses across the contacts 12 and 14 and across the contacts 13 and 15 which cause problems.

The protection diodes 16, 18, 20 and 22 are arranged, by selecting the appropriate conductivity concentration, to be conductive at a predetermined voltage level which level is greater than the supply voltage level of the device but which is less than the isolation layer's breakdown voltage. For example, with a supply voltage of 5V and a breakdown voltage of 250V, the protection diodes are preferably arranged to be conductive at 100V.

When an ESD pulse having a voltage level which is greater than the predetermined voltage level is present on the device contacts 12, 13, 14 and 15, the protection diodes 16, 18, 20 and 22 are rendered conductive which shorts the contacts 12, 13, 14, 15 to the semiconductor substrate. With shorted contacts, the semiconductor chemical sensor device cannot be damaged by the ESD pulses. The protection diodes 16, 18, 20 and 22 therefore protect the chemical sensor device for ESD pulses of greater than the predetermined voltage level.

The protection diodes 16, 18, 20 and 22 of the present invention are integrated into the semiconductor substrate. Two methods for fabricating a sensor device in accordance with preferred embodiments of the present invention will be described below. In both of the preferred embodiments, each protection diode comprises a P-N junction formed by the junction between the semiconductor substrate and a respective semiconductor diode region formed in the semiconductor substrate.

We now refer to FIG. 2, which shows a schematic top plan view of a first semiconductor chemical sensor device 200 in accordance with a first embodiment of the present invention. The first semiconductor chemical sensor device 200 comprises a sensitive layer 32 having contacts 33, 35, a heater 34 with contacts 36, 38, and protection diodes 40, 45, 55 and 65 having diode contacts 48, 49, 59, and 69, respectively. Each of the diode contacts 48, 49, 59 and 69 is coupled to a respective one of the contacts, 36, 38, 33 and 35 via conductors 51 such that each of the protection diodes 40, 45, 55, and 65 are coupled between a respective one of the contacts 36, 38, 33, and 35 and the semiconductor substrate (not shown in FIG. 2).

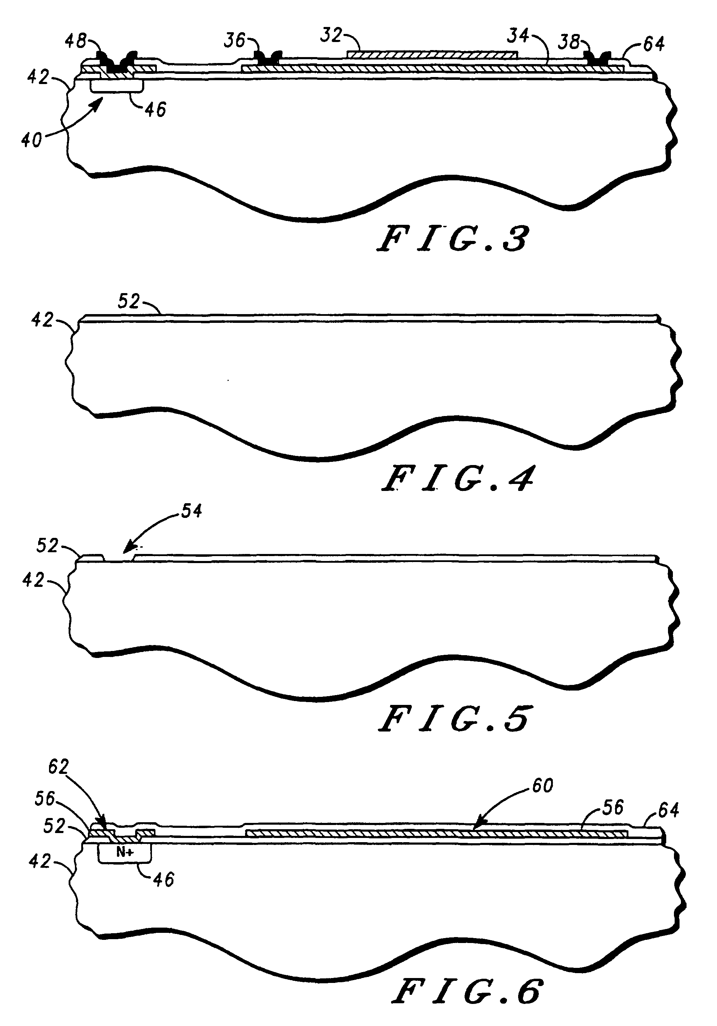

Reference is now made to FIG. 3, which shows a schematic cross-sectional diagram in the direction X of the first semiconductor chemical sensor device 200 of FIG. 2. An isolation layer 64 is formed between the heater 34 and sensitive layer 32. This isolation layer may be a single layer as shown in FIG. 3 or a sandwich of layers. The protection diode 40 comprises a P-N junction formed by the junction between the semiconductor substrate 42 and a semiconductor diode region 46 formed in the semiconductor substrate 42. Diode contact 48 of the protection diode 40 is coupled to contact 36 via a conductor (not shown in FIG. 3). Similar protection diodes (not shown in FIG. 3) are provided for the other contact 38 of the heater 34 and the contacts 33, 35 (not shown in FIG. 3) for the sensitive layer 32.

As discussed above, when an ESD pulse, having a voltage level greater than the predetermined voltage level, is applied to contact 36, the protection diode 40 becomes conducting and shorts the contact 36 to the semiconductor substrate 42 thereby protecting the first semiconductor chemical sensor device 200 from ESD damage.

A method for fabricating the first semiconductor chemical sensor device in accordance with the first embodiment will now be described with reference to FIGs. 2-9 of the drawings. Although in the following description the semiconductor substrate, layers and regions will be described as having certain conductivity types, this is for illustrative purposes only. It is not intended that the invention be limited to the specific conductivity types referred to herein.

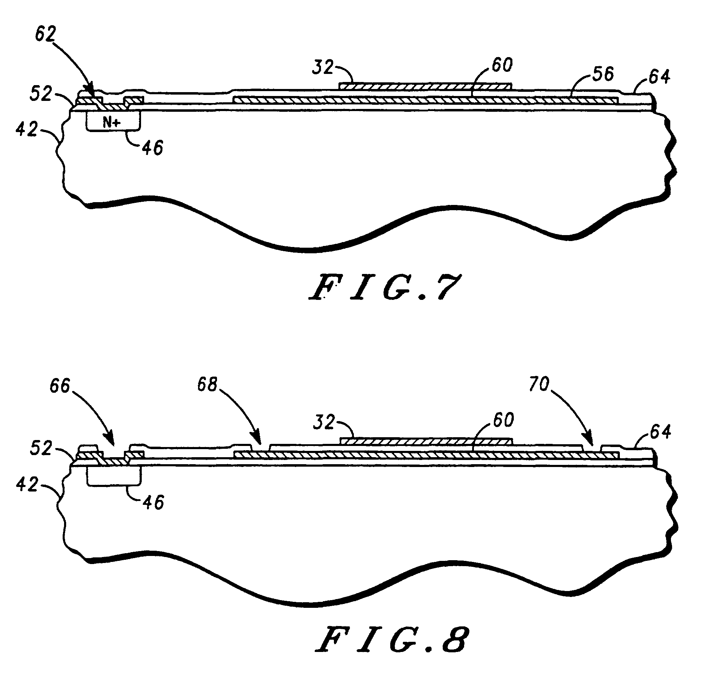

A first layer 52, such as a dielectric layer formed of thermal oxide material or nitride material, is first formed on the semiconductor substrate 42, such as a P-type <100> silicon substrate (FIG. 4). The first layer 52 is then patterned and etched using, for example, photolithographic techniques well known in the art, to form openings, only one 54 of which is shown in FIG. 5, in the first layer extending to the silicon substrate 42. In FIG. 6, a conductive layer 56, such as a polysilicon layer, is formed over the first layer 52. The polysilicon layer 56 is then doped with a dopant of N+ conductivity type by performing a predeposition step in a chamber with a dopant source. For a phosphorous dopant, phosphine gas is used as the dopant source. The wafer is then heated in a furnace, preferably at 950ºC for four hours, to diffuse the N+ dopant into the silicon substrate 42 so as to form the semiconductor diode region 46 in the silicon substrate 42 of N+ conductivity type. The P-N junction between the N+ semiconductor diode region 46 and the P silicon substrate 42 forms the protection diode 40 of the first semiconductor chemical sensor device.

The polysilicon layer 56 is then patterned and etched so as to provide a portion 60 of polysilicon layer 56 which forms the heater 34 for the first semiconductor chemical sensor device and a portion 62 which fills the opening 54 and extends a small distance over the first layer 52. An isolation layer 64 is then formed over the polysilicon layer 56 and the exposed portions of the first layer 52. Preferably, the isolation layer 64 is a TetraEthyle OrthoSilicate (TEOS) layer.

The sensitive layer 32 is then formed on the TEOS layer 64 so that it extends over the heater portion 60 (FIG. 7). The sensitive layer 32 is sensitive to the chemical species to be sensed by the sensor device. For example, in a carbon monoxide sensor, the sensitive layer 32 typically comprises a tin oxide layer. In another embodiment, an additional isolation layer (not shown) may be deposited on the TEOS layer 64 and the sensitive layer 32 formed on the additional isolation layer.

In FIG. 8, the TEOS layer 64 is patterned and etched to form openings 66, 68 and 70 in the TEOS layer 64 which openings extend to the polysilicon layer 56; opening 66 extends to the portion 62 of polysilicon layer 56 and openings 68 and 70 extend to the heater portion 60 of the polysilicon layer 56, respectively.

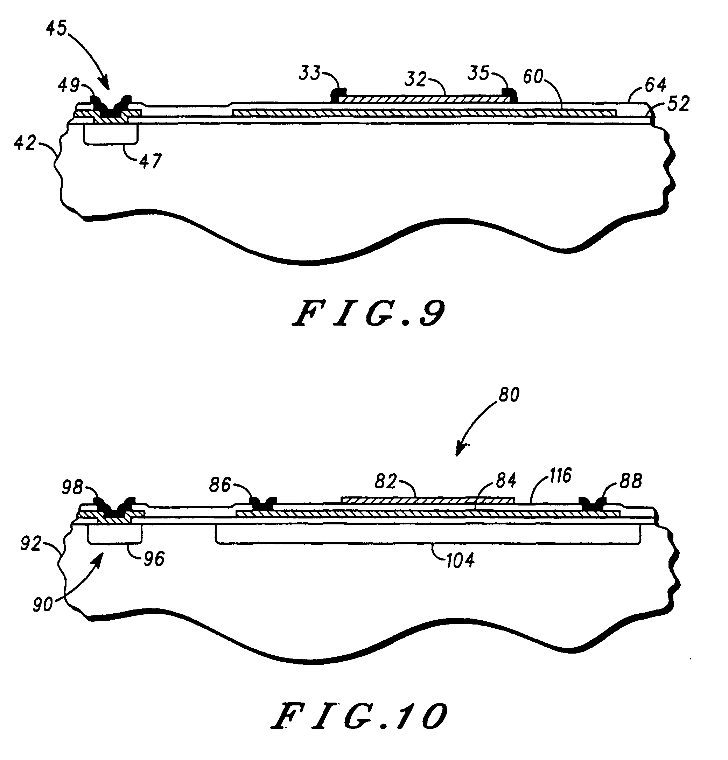

Referring now again to FIG. 3, metal is then deposited to form the diode contact 48 to the semiconductor diode region 46 (and diode contacts 49, 59, 69 not shown in FIG. 3), heater contacts 36, 38 and contacts 33, 35 (not shown in FIG. 3). FIG. 9 is a schematic cross-sectional diagram in the direction Y of the first semiconductor chemical sensor device 200 of FIG. 2 showing the contacts 33, 35 of the sensitive layer 32 and the protection diode 45 which comprises a semiconductor diode region 47 and a diode contact 49 coupled to contact 33 via a conductor (not shown in FIG. 9).

It will be appreciated that additional steps are required to completely fabricate the first semiconductor chemical sensor device 200 in accordance with the first embodiment of the present invention, such as back etching the silicon substrate 42 so that the first layer 52 is exposed in the region of the heater 34. However, this steps are well known in the art and not important for the understanding of the present invention.

Referring now to FIG. 10 which shows a schematic cross-sectional diagram of part 80 of a second semiconductor chemical sensor device fabricated in accordance with a second embodiment of the present invention. The second semiconductor chemical sensor device is similar to the first semiconductor chemical sensor device 200 except that an additional semiconductor region 104 is formed in the semiconductor substrate 92. The second semiconductor chemical sensor device comprises a sensitive layer 82, a heater 84 with contacts 86, 88, an isolation layer 116 between the heater 84 and sensitive layer 82 and a protection diode 90 formed in a semiconductor substrate 92.

The protection diode 90 comprises a P/N junction formed by the junction between the semiconductor substrate 92 and a semiconductor diode region 96 formed in the semiconductor substrate 92. Diode contact 98 of the protection diode 90 is coupled to contact 86 via a conductor (not shown). Similar protection diodes (not shown) are provided for the other contact 88 of the heater 84 and the contacts (not shown) for the sensitive layer 82.

As discussed above, when an ESD pulse, having a voltage level greater than the predetermined voltage level, is applied to contact 86, the protection diode 90 becomes conducting and shorts the contact 86 to the substrate 92 thereby protecting the second semiconductor chemical sensor device from ESD damage.

A method for fabricating the second semiconductor chemical sensor device in accordance with the second embodiment will now be described with reference to FIGs. 10-15 of the drawings.

A masking layer 100 is first formed on the semiconductor substrate 92, such as a P-type <100> silicon substrate (FIG.11). The masking layer 100 is then patterned and etched to form an opening 102 in the masking layer 100 to the silicon substrate 92. A P+ dopant is then deposited or implanted into the silicon substrate 92 through the opening 102 to form a first semiconductor region 104 of P+ conductivity type in the silicon substrate 92.

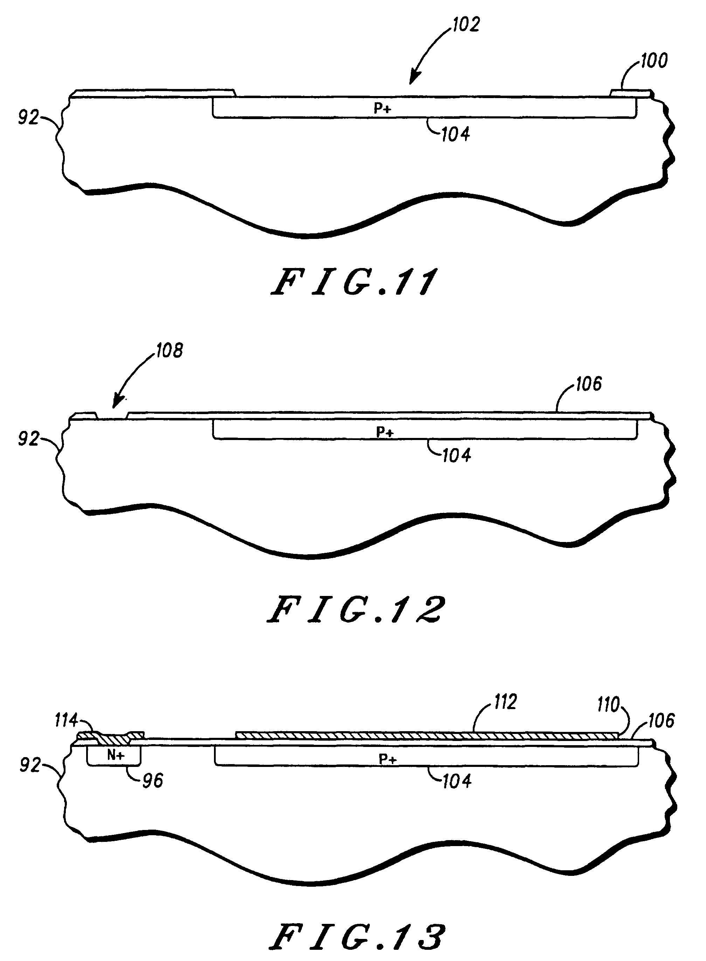

The masking layer 100 is removed and a first layer 106, such as a dielectric layer formed of thermal oxide material or nitride material, is formed on the silicon substrate 92 (FIG. 12). The first layer 106 is then patterned and etched to form openings, only one 108 of which is shown in FIG. 12 corresponding to one of the protection diodes, in the first layer 106 extending to the silicon substrate 92. In FIG. 13, a conductive layer 110, such as a polysilicon layer, is formed over the first layer 106. The polysilicon layer 110 is then doped with a dopant of N+ conductivity type and the wafer is then heated in a furnace, preferably at 950ºC for four hours, to diffuse the N+ dopant into the silicon substrate 92 so as to form the semiconductor diode region 96 in the silicon substrate 92 of N+ conductivity type. The P/N junction between the N+ semiconductor diode region 96 and the P silicon substrate 92 forms the protection diode 90 of the second semiconductor chemical sensor device.

The polysilicon layer 110 is then patterned and etched so as to provide a portion 112 of polysilicon layer 110 which forms the heater 84 for the second semiconductor chemical sensor device and a portion 114 which fills the opening 108 and extends a small distance over the first isolation layer 106.

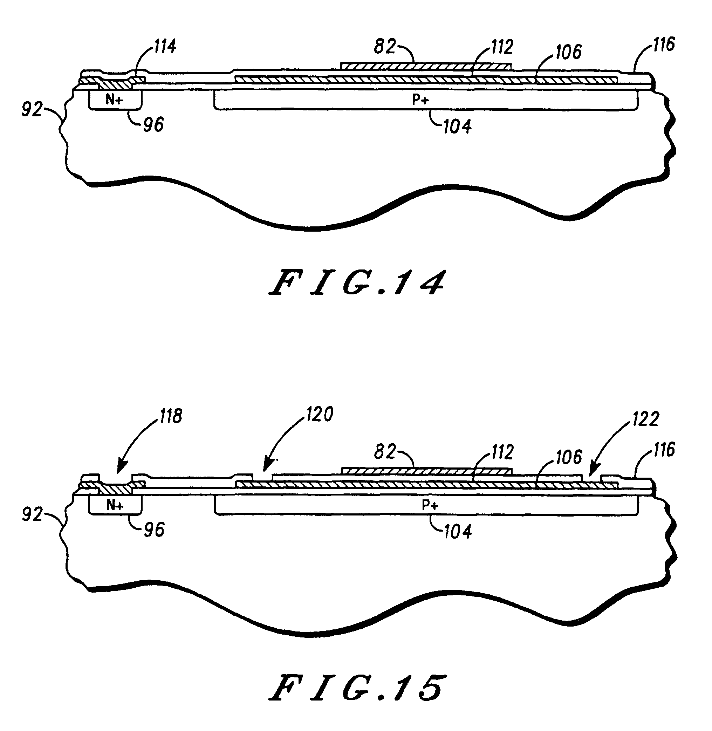

An isolation layer 116 is then formed over the polysilicon layer 110 and the exposed portions of the first layer 106 (FIG. 14). Preferably, the isolation layer 116 is a TetraEthyle OrthoSilicate (TEOS) layer. A second isolation layer 124 (not shown) may be formed on the TEOS layer 116. The sensitive layer 82 is then formed on the TEOS layer 116 or second isolation layer 124 so that it extends over the heater portion 112.

The TEOS layer 116 is patterned and etched to form openings 118, 120, 122 in the TEOS layer 116 which openings extend to the polysilicon layer 110 (FIG. 15); opening 118 extends to the portion 114 of polysilicon layer 110 and openings 120 and 122 extend to the heater portion 112 of the polysilicon layer 110, respectively.

Referring again to FIG. 10, metal is then deposited to form the diode contact 98 to the semiconductor diode region 96 (and the other diode contacts not shown in FIG. 10), heater contacts 86, 88 and the contacts to the sensitive layer 82 (not shown in FIG. 10).

As with the first embodiment, additional steps are required to completely fabricate the second semiconductor chemical sensor device, which since they are well known in the art, will not be described in detail here.

An advantage of the present invention is that the protection diodes for protecting the sensor device against ESD pulses can be formed using materials which are already existing in the fabrication process: that is, the silicon substrate and the doped polysilicon layer which is used to form the heater.

Moreover, a particular advantage of the method in accordance with the first embodiment of the invention is that only one additional masking and etching step (to form the opening 54 in the first layer 52) is required to form the protection diodes.

## Claims

1. A sensor device formed on a semiconductor substrate (42; 92) comprising a sensitive layer (32; 82) having contacts (33, 35) thereto and a heater (34; 84) for heating the sensitive layer and having contacts (36, 38; 86, 88) thereto, the sensor device further comprising protection diodes (40, 45, 55, 65; 90) formed in the semiconductor substrate, each protection diode being coupled between a respective one of the sensitive layer contacts and heater contacts and the semiconductor substrate.

2. A sensor device according to claim 1, wherein each protection diode comprises a P-N junction formed by a junction between the semiconductor substrate (42; 92) and a respective semiconductor diode region (46; 96) formed in the semiconductor substrate.

3. A method of fabricating a sensor device comprising a sensitive layer and a heater for heating the sensitive layer, the method comprising the steps of:
providing a semiconductor substrate (42) of a first conductivity type;
forming a conductive layer (56) over the semiconductor substrate and removing some of the conductive layer to leave a heater portion (60) which forms the heater,
forming a sensitive layer (32) so that it extends over the heater;
forming contacts to the heater and to the sensitive layer;
forming protection diodes (46) in the semiconductor substrate, each protection diode being coupled between a respective one of the sensitive layer contacts and heater contacts and the semiconductor substrate.

4. A method according to claim 3, wherein the step of forming the protection diodes comprises the steps of:
forming semiconductor diode regions of a second conductivity type in the semiconductor substrate, each semiconductor diode region being associated with a respective one of the sensitive layer and heater contacts; and
forming a diode contact (56) for each of the semiconductor diode regions such that each of the diode contacts is coupled to a respective one of the heater and sensitive layer contacts.

5. A method according to claim 4, wherein the step of forming semiconductor diode regions in the semiconductor substrate comprises the steps of:
doping the conductive layer with a dopant of a second conductivity type;
diffusing the dopant into the semiconductor substrate so as to form the semiconductor diode regions of the second conductivity type in the semiconductor substrate.

6. A method according to claim 3, further comprising the steps of:
forming a first layer (52) over the semiconductor substrate; and
patterning and etching the first layer so as to provide openings to the semiconductor substrate, each opening being associated with a respective one of the sensitive layer and heater contacts;
wherein the step of forming a conductive layer over the semiconductor substrate comprises forming the conductive layer over the first layer such that the conductive layer fills the openings and wherein the step of removing part of the conductive layer comprises removing part of the conductive layer so as to leave the heater portion and other portions which fill the openings;
doping the conductive layer with a dopant of a second conductivity type;
diffusing the dopant into the semiconductor substrate through the openings so as to form semiconductor diode regions of the second conductivity type in the semiconductor substrate;
forming an isolation layer (64) over the first layer and the heater and other portions of the conductive layer;
forming the sensitive layer over the isolation layer so that it extends over the heater portion of the conductive layer;
patterning and etching the isolation layer so as to provide openings to the heater portion and the other portions of the conductive layer; and
depositing metal to form the contacts to the sensitive layer and to fill the openings with metal so as to form contacts to the heater portion and diode contacts to the semiconductor diode regions.

7. A method according to claim 6, wherein the first layer comprises a dielectric layer.

8. A method according to claim 6 or 7, further comprising, before the step of forming the first layer, the steps of:
forming a masking layer over the semiconductor substrate;
patterning and etching the masking layer so as to provide an opening to the semiconductor substrate; and
doping the semiconductor substrate through the opening so as to form a semiconductor region in the semiconductor substrate.

9. A method according to claim 5, 6, 7 or 8, wherein the step of diffusing the dopant comprises the step of:
heating the device in a furnace at approximately 950°C for at least four hours.

10. A sensor device according to claim 1 or 2, wherein the sensor device further comprises an isolation layer (64; 116) between the sensitive layer (32; 82) and heater (34; 84) and wherein the protection diodes are arranged to be conductive at a predetermined voltage level which level is greater than a supply voltage level of the sensor device but which is less than a breakdown voltage of the isolation layer.

11. A method according to claim 3,4 or 5 wherein the sensor device further comprises an isolation layer (64;116) between the sensitive layer (32;82) and heater (34;84) and wherein the protection diodes are arranged to be conductive at a predetermined voltage level which level is greater than a supply voltage level of the sensor device but which is less than a breakdown voltage of the isolation layer.

## Patentansprüche

1. Auf einem Halbleitersubstrat (42; 92) gebildetes Sensorbauelement, aufweisend eine sensitive Schicht (32; 82) mit Kontakten (33, 35) zu dieser und eine Heizeinrichtung (34; 84) mit Kontakten (36, 38; 86, 88) zu dieser, um die sensitive Schicht zu erwärmen, wobei das Sensorbauelement überdies in dem Halbleitersubstrat gebildete Schutzdioden (40, 45, 55, 65; 90) aufweist, von denen jede Schutzdiode zwischen einem jeweiligen Kontakt der Kontakte der sensitiven Schicht und der Heizeinrichtungs-Kontakte und dem Halbleitersubstrat angeschlossen ist.

2. Sensorbauelement nach Anspruch 1, wobei jede Schutzdiode einen pn-Übergang aufweist, der durch einen Übergang zwischen dem Halbleitersubstrat (42; 92) und einem entsprechenden Halbleiter-Diodenbereich (46; 96) gebildet ist, der in dem Halbleitersubstrat gebildet ist.

3. Verfahren zur Herstellung eines Sensorbauelements, das eine sensitive Schicht und eine Heizeinrichtung zum Erwärmen der sensitiven Schicht aufweist, wobei das Verfahren folgende Schritte aufweist:
Vorsehen eines Halbleitersubstrats (42) eines ersten Leitfähigkeitstyps;
Bilden einer Leitungsschicht (56) über dem Halbleitersubstrat und teilweises Entfernen der Leitungsschicht, um einen Heizeinrichtungs-Bereich (60) zu belassen, der die Heizeinrichtung bildet;
Bilden einer sensitiven Schicht (32), derart, dass sich diese über die Heizeinrichtung erstreckt;
Bilden von Kontakten zu der Heizeinrichtung und zu der sensitiven Schicht;
Bilden von Schutzdioden (46) in dem Halbleitersubstrat, wobei jede Schutzdiode zwischen einem jeweiligen Kontakt der Kontakte der sensitiven Schicht und der Heizeinrichtungs-Kontakte und dem Halbleitersubstrat angeschlossen ist.

4. Verfahren nach Anspruch 3, wobei der Schritt des Bildens der Schutzdioden die Schritte aufweist:
Bilden von Halbleiter-Diodenbereichen eines zweiten Leitfähigkeitstyps in dem Halbleitersubstrat, wobei jeder Halbleiter-Diodenbereich einem jeweiligen Kontakt der Kontakte der sensitiven Schicht und der Heizeinrichtungs-Kontakte zugeordnet ist; und
Bilden eines Diodenkontakts (56) für jeden der Halbleiter-Diodenbereiche derart, dass jeder der Diodenkontakte an einem jeweiligen Kontakt der Heizeinrichtungs-Kontakte und der Kontakte der sensitiven Schutzschicht angeschlossen ist.

5. Verfahren nach Anspruch 4, wobei der Schritt des Bildens der Halbleiter-Diodenbereiche in dem Halbleitersubstrat die Schritte aufweist:
Dotieren der Leitungsschicht mit einem Dotierstoff eines zweiten Leitfähigkeitstyps;
Eindiffundieren des Dotierstoffs in das Halbleitersubstrat, um die Halbleiter-Diodenbereiche des zweiten Leitfähigkeitstyps in dem Halbleitersubstrat zu bilden.

6. Verfahren nach Anspruch 3, das überdies die Schritte aufweist:
Bilden einer ersten Schicht (52) über dem Halbleitersubstrat; und
Mustern und Ätzen der ersten Schicht, um Öffnungen zu dem Halbleitersubstrat zu schaffen, wobei jede Öffnung einem jeweiligen Kontakt der Kontakte der sensitiven Schicht und der Heizeinrichtungs-Kontakte zugeordnet ist;
wobei der Schritt des Bildens einer Leitungsschicht über dem Halbleitersubstrat die Bildung der Leitungsschicht über der ersten Schicht derart umfasst, dass die Leitungsschicht die Öffnungen ausfüllt, und wobei der Schritt des teilweisen Entfernens der Leitungsschicht das teilweise Entfernen der Leitungsschicht umfasst, um den Heizeinrichtungs-Bereich und andere Bereiche zu belassen, die die Öffnungen ausfüllen;
Dotieren der Leitungsschicht mit einem Dotierstoff eines zweiten Leitfähigkeitstyps;
Eindiffundieren des Dotierstoffs in das Halbleitersubstrat durch die Öffnungen, um Halbleiter-Diodenbereiche des zweiten Leitfähigkeitstyps in dem Halbleitersubstrat zu bilden;
Bilden einer Isolierschicht (64) über der ersten Schicht und der Heizeinrichtung und anderen Bereichen der Leitungsschicht;
Bilden einer sensitiven Schicht über der Isolierschicht, so dass sich diese über den Heizeinrichtungs-Bereich der Leitungsschicht erstreckt;
Mustern und Ätzen der Isolierschicht, um Öffnungen zu dem Heizeinrichtungs-Bereich und den anderen Bereichen der Leitungsschicht zu schaffen; und
Aufbringen von Metall, um die Kontakte zu der sensitiven Schicht zu bilden und um die Öffnungen mit Metall zu füllen, um so Kontakte zu dem Heizeinrichtungs-Bereich und Diodenkontakte zu den Halbleiter-Diodenbereichen zu bilden.

7. Verfahren nach Anspruch 6, wobei die erste Schicht eine dielektrische Schicht aufweist.

8. Verfahren nach Anspruch 6 oder 7, das vor dem Schritt des Bildens der ersten Schicht überdies die Schritte aufweist:
Bilden einer Maskierungsschicht über dem Halbleitersubstrat;
Mustern und Ätzen der Maskierungsschicht, um eine Öffnung zu dem Halbleitersubstrat zu bilden; und
Dotieren des Halbleitersubstrats durch die Öffnung, um einen Halbleiterbereich in dem Halbleitersubstrat zu bilden.

9. Verfahren nach Anspruch 5, 6, 7 oder 8, wobei der Schritt des Diffundierens des Dotierstoffs den Schritt aufweist:
Erwärmen des Bauelements in einem Ofen bei näherungsweise 950° C für mindestens vier Stunden.

10. Sensorbauelement nach Anspruch 1 oder 2, wobei das Sensorbauelement überdies eine Isolierschicht (64; 116) zwischen der sensitiven Schicht (32; 82) und der Heizeinrichtung (34; 84) aufweist und wobei die Schutzdioden dazu ausgelegt sind, bei einem vorbestimmten Spannungspegel zu leiten, der höher als ein Versorgungsspannungspegel des Sensorbauelements, jedoch niedriger als die Durchschlagspannung der Isolierschicht ist.

11. Verfahren nach Anspruch 3, 4 oder 5, wobei das Bauelement überdies eine Isolierschicht (64; 116) zwischen der sensitiven Schicht (32; 82) und der Heizeinrichtung (34; 84) aufweist und wobei die Schutzdioden dazu ausgelegt sind, bei einem vorbestimmten Spannungspegel zu leiten, der höher als ein Versorgungsspannungspegel des Sensorbauelements, jedoch niedriger als die Durchschlagspannung der Isolierschicht ist.

## Revendications

1. Dispositif de détection formé sur un substrat semi-conducteur (42 ; 92) comprenant une couche sensible (32 ; 82) ayant des contacts (33, 35) qui y mènent, et un élément chauffant (34 ; 84) destiné à chauffer la couche sensible et ayant des contacts (36, 38 ; 86, 88) qui y mènent, le dispositif de détection comprenant, en outre, des diodes de protection (40, 45, 55, 65 ; 90) formées dans le substrat semi-conducteur, chaque diode de protection étant couplée entre l'un correspondant des contacts de la couche sensible et des contacts de l'élément chauffant et le substrat semi-conducteur.

2. Dispositif de détection selon la revendication 1, dans lequel chacune des diodes de protection comprend une jonction P-N formée par une jonction entre le substrat semi-conducteur (42 ; 92) et une région de diode semi-conductrice correspondante (46 ; 96) formée dans le substrat semi-conducteur.

3. Procédé de fabrication d'un dispositif de détection comprenant une couche sensible et un élément chauffant destiné à chauffer la couche sensible, le procédé comprenant les étapes qui consistent à :
prévoir un substrat semi-conducteur (42) ayant un premier type de conductivité ;
former une couche conductrice (56) sur le substrat semi-conducteur et retirer une certaine partie de la couche conductrice, de manière laisser une partie formant élément chauffant (60) qui constitue l'élément chauffant ;
former une couche sensible (32) de telle sorte qu'elle s'étende au-dessus de l'élément chauffant ;
former des contacts menant à l'élément chauffant et à la couche sensible ;
former des diodes de protection (90) dans le substrat semi-conducteur, chaque diode de protection étant couplée entre l'un correspondant des contacts de la couche sensible et des contacts de l'élément chauffant et le substrat semi-conducteur.

4. Procédé selon la revendication 3, dans lequel l'étape qui consiste à former les diodes de protection comprend les étapes qui consistent à :
former des régions de diodes semi-conductrices d'un deuxième type de conductivité dans le substrat semi-conducteur, chaque région de diode semi-conductrice étant associée à l'un correspondant des contacts de la couche sensible et des contacts de l'élément chauffant ; et
former un contact de diode (56) pour chacune des régions de diodes semi-conductrices, de telle sorte que chacun des contacts de diode soit couplé à l'un correspondant des contacts de la couche sensible et des contacts de l'élément chauffant.

5. Procédé selon la revendication 4, dans lequel l'étape qui consiste à former les régions de diodes semi-conductrices dans le substrat semi-conducteur comprend les étapes qui consistent à :
doper la couche conductrice avec un dopant ayant un deuxième type de conductivité ;
diffuser le dopant dans le substrat semi-conducteur de façon à former les régions de diodes semi-conductrices du deuxième type de conductivité dans le substrat semi-conducteur.

6. Procédé selon la revendication 3, comprenant, en outre, les étapes qui consistent à :
former une première couche (52) sur le substrat semi-conducteur ; et
structurer et graver la première couche pour réaliser des ouvertures vers le substrat semi-conducteur, chaque ouverture étant associée à l'un correspondant des contacts de la couche sensible et des contacts de l'élément chauffant ;
où l'étape qui consiste à former une couche conductrice sur le substrat semi-conducteur consiste à former la couche conductrice sur la première couche de telle sorte que la couche conductrice remplisse les ouvertures, et où l'étape qui consiste à retirer une partie de la couche conductrice consiste à retirer une partie de la couche conductrice de façon à laisser la partie formant élément chauffant et d'autres parties qui remplissent les ouvertures ;
doper la couche conductrice avec un dopant ayant un deuxième type de conductivité ;
diffuser le dopant dans le substrat semi-conducteur à travers les ouvertures, de façon à former des régions de diodes semi-conductrices du deuxième type de conductivité dans le substrat semi-conducteur ;
former une couche isolante (64) sur la première couche et sur la partie formant élément chauffant et les autres parties de la couche conductrice ;
former la couche sensible sur la couche isolante, de telle sorte qu'elle s'étende au-dessus de la partie formant élément chauffant de la couche conductrice ;
structurer et graver la couche isolante de façon à réaliser des ouvertures vers la partie formant élément chauffant et les autres parties de la couche conductrice ; et
déposer du métal pour former les contacts menant à la couche sensible et pour remplir les ouvertures de métal afin de former des contacts menant à la partie formant élément chauffant et des contacts de diodes menant aux régions de diodes semi-conductrices.

7. Procédé selon la revendication 6, dans lequel la première couche comprend une couche diélectrique.

8. Procédé selon la revendication 6 ou 7, comprenant, en outre, avant l'étape de formation de la première couche, les étapes qui consistent à :
former une couche de masquage sur le substrat semi-conducteur ;
structurer et graver la couche de masquage de façon à réaliser une ouverture vers le substrat semi-conducteur ; et
doper le substrat semi-conducteur à travers l'ouverture, de façon à former une région semi-conductrice dans le substrat semi-conducteur.

9. Procédé selon la revendication 5, 6, 7 ou 8, dans lequel l'étape de diffusion du dopant comprend l'étape qui consiste à :
chauffer le dispositif dans un four à environ 950°C pendant au moins quatre heures.

10. Dispositif de détection selon la revendication 1 ou 2, dans lequel le dispositif de détection comprend, en outre, une couche isolante (64 ; 116) entre la couche sensible (32 ; 82) et l'élément chauffant (34 ; 84), et dans lequel les diodes de protection sont conçues de manière à être conductrices à un niveau de tension prédéterminé, lequel niveau est supérieur à un niveau de tension d'alimentation du dispositif de détection, mais est inférieur à une tension de rupture de la couche isolante.

11. Procédé selon la revendication 3, 4 ou 5, dans lequel le dispositif de détection comprend, en outre, une couche isolante (64 ; 116) entre la couche sensible (32 ; 82) et l'élément chauffant (34 ; 84), et dans lequel les diodes de protection sont conçues de manière à être conductrices à un niveau de tension prédéterminé, lequel niveau est supérieur à un niveau de tension d'alimentation du dispositif de détection, mais est inférieur à une tension de rupture de la couche isolante.
